# EUROPEAN PATENT SPECIFICATION

(11) **EP 4 172 639 B1**
(45) Date of publication and mention of the grant of the patent: **04.06.2025**
(21) Application number: 21752733.2
(22) Date of filing: 24.06.2021
(51) Int. Cl.: G01R 31/3835

(54) **BATTERY CHARACTERIZATION SYSTEM AND METHOD**
SYSTEM UND VERFAHREN ZUR BATTERIECHARAKTERISIERUNG
SYSTÈME ET PROCÉDÉ DE CARACTÉRISATION DE BATTERIES

(30) Priority: 25.06.2020 US 202063044085 P
(43) Date of publication of application: 03.05.2023
(73) Proprietor: Analog Devices International Unlimited Company, Co. Limerick (IE)
(72) Inventor: KASSELMAN, Pieter Retief, Dublin D16 NW 27 (IE); RYAN, Rosemary B., Limerick (IE); O'MAHONY, Shane, Cork (IE); COX, Brian, Galway H91 XN3F (IE); LYDEN, Colin, Gerard, Cork (IE); DALY, Brendan, Cork 94027 (IE); MALAVER, Lewis, Weston, MA 02493 (US)
(74) Representative: Horler, Philip John
(86) International application number: PCT/IB2021/000434
(87) International publication number: WO 2021/260433

(56) References cited:
- EP-A1- 0 323 539
- EP-A1- 2 362 478
- JP-A- H04 250 376
- US-A1- 2009 189 614

## Description

### FIELD OF THE DISCLOSURE

The present application relates to battery cell characterization. A characterization of a battery cell generated using techniques described herein may be used, for example, to match battery cells with similar electrical characteristics and/or to verify authenticity of the battery cell.

### BACKGROUND

A battery may include multiple battery cells. For example, a battery may include multiple battery cells connected in series to provide higher voltage. The battery may be used to provide electrical energy to a device. The battery may provide a mobile power source for the device. For example, the battery may be used to power an electric vehicle, a mobile computing device, or portable electronics. Performance of the battery may be determined by the characteristics of the battery cells in the battery. Multiple battery packs may be coupled together. Battery cells and modules may be selected to form a particular battery pack having desirable operating characteristics.
EP 2362478 A1 discloses a determination system for determining whether metal lithium is precipitated in a lithium ion secondary battery by acquiring a natural increase in voltage of the lithium ion secondary battery after a constant current discharge is terminated.
EP 0323539 A1 discloses a method for determining the state-of-charge of batteries having constant discharge curves. After a short rest period, the method comprises measuring the open circuit voltage of the battery.
US 2009/089614 A1 discloses a fuel gauging system which detects an electrochemical composition of a power source and then determines a state of charge of the power source based upon the determined electrochemical composition of the power source.

### BRIEF SUMMARY

Described herein are techniques of characterizing electrical characteristics of a battery cell. The techniques employ a battery monitor coupled to a battery to measure voltage of the battery cell when it is in a recovery state after application of a stimulus (e.g., discharging or charging the battery). The measured voltage of the battery cell in the recovery state is then used to generate a characterization of the battery cell. The characterization may be used, for example, to match the battery cell with one or more similar battery cells to be coupled in a battery pack. In another example, the characterization may be used to verify authenticity of the battery cell.

In some embodiments, a battery monitor as defined in claim 1 is provided.

In some embodiments, a method as defined in claim 10 is provided.

In an example that is not claimed a system is provided. The system comprises: a processor; and a non-transitory computer-readable storage medium storing instructions that, when executed by the processor, cause the processor to: receive at least one first voltage measurement of a first cell of a battery, the at least one first voltage measurement obtained in a first time period in which the battery was in a recovery state after a discharge of current from the battery; and generate a first characterization for the first cell using the at least one first voltage measurement.

In some embodiments, the first cell of the first battery is matched to a second cell of a second battery using the first characterization for the first cell. In some embodiments, matching the first cell of the first battery to the second cell of the second battery using the first characterization comprises: comparing the first characterization for the first cell to a second characterization for the second cell to determine a measure of similarity between the first cell and the second cell; and matching the first cell to the second cell based on the measure of similarity.

In some embodiments, at least one second voltage measurement of the first cell is received as well as the at least one second voltage measurement obtained in a second time period in which the battery was being discharged; and the first characterization for the first cell is generated using the at least one second voltage measurement. In some embodiments, verifying the identity of the first cell using the first characterization of the first cell comprises comparing the first characterization of the first cell to an expected characterization of the first cell. In some embodiments, the expected characterization of the first cell comprises a previously generated characterization of the first cell.

### BRIEF DESCRIPTION OF DRAWINGS

Various non-limiting embodiments of the technology are described herein with reference to the following figures. It should be appreciated that the figures are not necessarily drawn to scale. Items appearing in multiple figures are indicated by the same reference numeral in all figures in which they appear. For purposes of clarity, not every component may be labeled in every drawing.
FIG. 1 illustrates an example of a system for monitoring fleets of batteries, according to some embodiments of the technology described herein.
FIG. 2 illustrates a battery cell, battery module, and battery pack, according to some embodiments of the technology described herein.
FIG. 3 illustrates a subsystem comprising a wireless battery management system (WBMS) node and a gateway, according to some embodiments of the technology described herein.
FIG. 4 illustrates a subsystem comprising a WBMS node and a gateway, according to some embodiments of the technology described herein.
FIG. 5 illustrates a method for monitoring batteries throughout their lifecycle, according to some embodiments of the technology described herein.
FIG. 6 illustrates an example of a configuration for monitoring a battery in storage, according to some embodiments of the technology described herein.
FIG. 7 illustrates an example method of performing a measurement on a battery, according to some embodiments of the technology described herein.
FIG. 8 illustrates an example plot of data collected from performing a measurement on a battery, according to some embodiments of the technology described herein.
FIG. 9 illustrates an example method of matching a battery cell to another battery cell, according to some embodiments of the technology described herein.
FIG. 10 illustrates an example method of verifying authenticity of a battery cell, according to some embodiments of the technology described herein.
FIGs. 11A-11D illustrate example Nyquist plots of impedances of a battery cell and an expected impedance of the battery cell, according to some embodiments of the technology described herein.
FIG. 12 illustrates an example computer system which may be used to implement some embodiments of the technology described herein.

### DETAILED DESCRIPTION

Aspects of the present application provide techniques for characterizing a cell of a battery by using measurements of the battery cell obtained while the battery is in a recovery state. A recovery state is when a voltage of the battery cell is changing after removal of a stimulus that was previously applied to the battery. A stimulus may be discharging or charging of the battery. Due to manufacturing variances, aging, impurities, environmental exposures, and other factors battery cells may have differences in electrical characteristics that affect performance of the battery cells. For example, different battery cells of the same model may have different respective capacities due to the physical differences. Coupling battery cells with similar electrical characteristics in a battery pack may improve performance and efficiency of the battery pack. For example, a battery pack with lower variance in capacity among its battery cells may have increased performance in terms of charging speed, lifetime, and range. Moreover, including similar battery cells in a battery pack allows the battery pack to be balanced more efficiently.

The inventors have developed a technique to characterize a battery cell that uses measurements of the battery cell obtained while the battery in a recovery state. By incorporating measurements obtained while the battery is in a recovery state, the techniques may provide more accurate characterization of a battery cell than conventional techniques that only use measurements obtained while the battery is discharging or charging. The measurements obtained while the battery is in a recovery state may provide additional information about electrical characteristics of a battery cell, and may augment information provided from measurements obtained during discharge or charge of the battery. Further, the additional information provided by the recovery state measurements may allow a sensor to use a lower discharge current in obtaining measurements when the battery is in an active state. Thus, techniques described herein may improve power efficiency of sensors in obtaining measurements to characterize a battery cell.

In some embodiments, the characterization of a battery cell may be used to match the battery cell with one or more other battery cells to include in a battery (e.g., to improve performance of the battery). For example, the characterization may be used to match the battery cell with one or more other battery cells during assembly of a battery pack. In some embodiments, the characterization of a battery cell may be used to verify authenticity of the battery cell. For example, the characterization may be used to verify that the battery cell is one manufactured by an approved manufacturer and/or that the battery cell is not counterfeit.

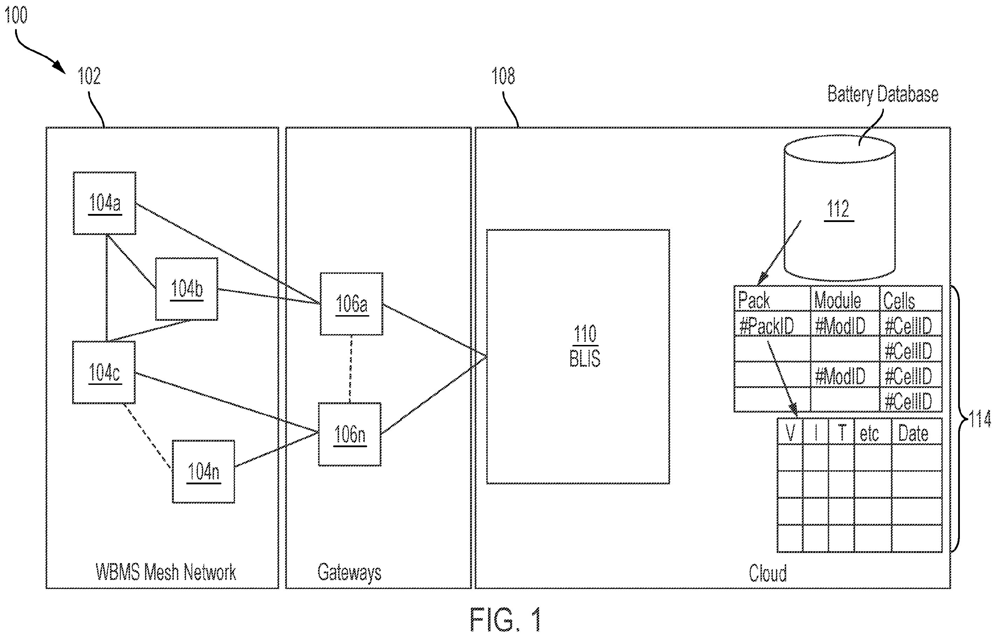

FIG. 1 illustrates an example of a battery management system 100 for monitoring fleets of batteries, according to some embodiments of the technology described herein. The battery management system 100 comprises a wireless battery management system (WBMS) mesh network 102 of WBMS nodes 104a, 104b, 104c...104n, a plurality of gateways 106a...106n, and a data aggregation and management module 108. The data aggregation and management module 108 implements a battery lifecycle insight system (BLIS) service 110 and maintains a battery database 112.

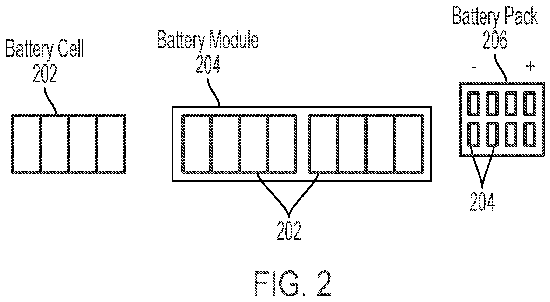

The WBMS mesh network 102 comprises WBMS nodes 104a, 104b, 104c...104n. In some embodiments, a WBMS mode comprises a battery and a battery monitor. In some embodiments, the battery monitor is integrated with the battery. In some embodiments, the battery monitor is attached to the battery, for example taking the form of a dongle. FIGs. 2-4, described further below, illustrate non-limiting examples of WBMS nodes. No matter the form, the WBMS nodes 104a...104n are configured to communicate wirelessly with a gateway (e.g., gateway 106a or gateway 106n), as described further below. For example, a WBMS node may send identifiers (battery cell ID, battery module ID, and/or battery pack ID) and measurement data 114 to the gateways 106a...106n, which in turn may provide them to the BLIS service 110.

In some embodiments, the BLIS service 110 is maintained at a location remote from the batteries. The BLIS service 110 stores the identifiers and the measurement data in the battery database 112. In some embodiments, the BLIS service 110 may be implemented using one or more computing devices. For example, the BLIS service 110 may be implemented using one or more servers. In some embodiments, the BLIS service 110 may be a cloud-based service. The cloud-based service may be distributed over multiple computing devices (e.g., servers) in different locations.

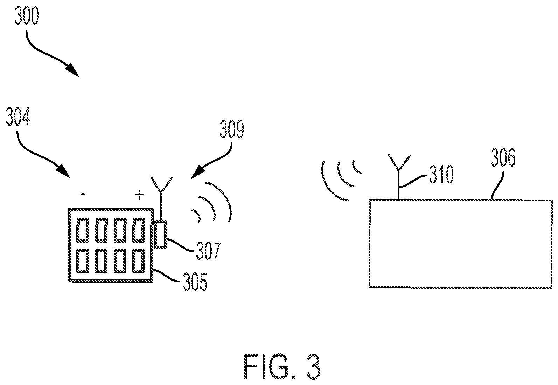

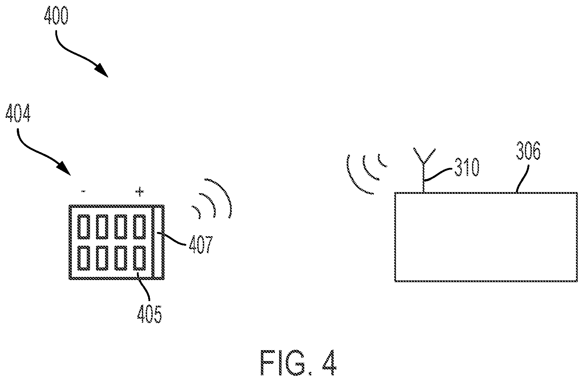

Batteries, such as those that make up the WBMS nodes 104a...104n, may be constructed of battery cells that are grouped into battery modules, which in turn are grouped into a battery pack. Referring to FIG. 2, battery cells 202 may be the smallest discrete unit of a battery. Different companies may manufacture different types of battery cells, with different chemical compositions. Companies may have proprietary battery cell compositions. Battery cells 202 may be grouped into a battery module 204. For example, battery cells 202 may be connected in series or in parallel in the battery module 204. Battery modules 204 may include any suitable number of battery cells 202. In the non-limiting example of FIG. 2, the battery module 204 includes two battery cells 202. However, the aspects described herein as utilizing battery modules are not limited to the modules including any specific number of battery cells. A battery pack 206 comprises a plurality of battery modules 204. In the non-limiting example shown, the battery pack 206 comprises eight battery modules 204. However, the aspects described herein as utilizing battery packs are not limited to the packs including any specific number of battery modules. As illustrated in FIGs. 3 and 4, described further below, the WBMS nodes additionally include a sensor and wireless communication mechanism.

Returning to FIG. 1, any suitable number of WBMS nodes 104a...104n may be part of the battery management system 100. The WBMS nodes 104a...104n make up a fleet of batteries in some embodiments. The fleet may include tens of batteries, hundreds of batteries, or thousands of batteries, as non-limiting examples. The WBMS nodes, or at least some of them, may be configured to communicate with each other, thus forming a mesh network. In this manner, data may be shared between WBMS nodes. For example, battery data from one WBMS node may be passed to another, from which it may be passed to a gateway. Also, instructions or software updates may be passed from a gateway to one WBMS node, and then from that WBMS node to another WBMS node of the mesh network.

The WBMS nodes 104a...104n may be different types of batteries, including batteries made by different manufacturers. In some embodiments, the batteries may all be of the same type, for example if a manufacturer is implementing the battery management system. However, the battery management system 100 may be implemented by entities other than manufacturers, who may use it to monitor fleets of batteries of different types. For example, a distributor who distributes batteries from many different manufacturers may implement the battery management system 100 to monitor and manage batteries it distributes for the different manufacturers.

The WBMS nodes 104a...104n may be at any suitable locations, and in some situations the locations may change. Some of the WBMS nodes may be co-located, for example in a warehouse or other storage facility, while others may be positioned at separate locations. For example, some of the WBMS nodes may represent batteries deployed in the field, for example in electric vehicles, ships, or planes, and therefore the location may change. Also, the battery management system 100 may be used to monitor WBMS nodes when in transit, for example in shipping containers.

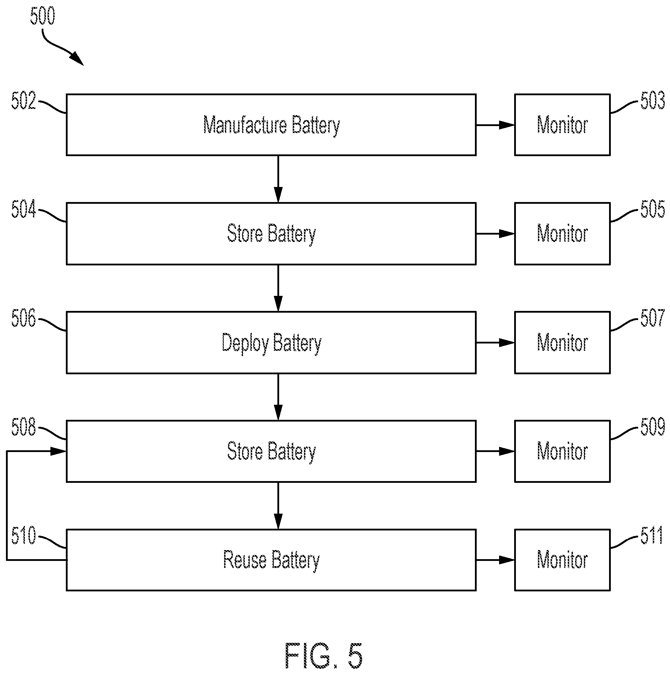

The WBMS nodes 104a...104n may be in various states of usage, as will be described further below in greater detail with reference to FIG. 5. As has been described above, monitoring of batteries in non-operational states may be desirable and provided by the battery management system 100. One or more of the WBMS nodes 104a...104n may be in a non-operational state. For example, one or more of the WBMS nodes 104a...104n may be in storage, or being transported from one location to another. Batteries often spend a significant amount of time in non-use before being deployed, or between different deployments. During such times, the batteries may degrade. Thus, monitoring their state of health only when in use risks losing valuable information and could result in damage to property or people, or decisions to deploy batteries that are not suitable for a particular application or for any application, thus requiring replacement. Time and money may be lost as a result. Accordingly, the inventors have recognized the importance of monitoring battery fleets even when those batteries are not in use.

In some embodiments, the gateways 106a...106n serve to aggregate data from multiple WBMS nodes and provide the data to the data aggregation and management module 108. The gateways are wirelessly enabled, to allow for wireless communication with the WBMS nodes, and may communicate wirelessly or through a wired network with the data aggregation and management module 108. The gateways 106a...106n may be positioned at any suitable locations to collect data from the WBMS nodes. For example, a warehouse storing batteries may have one or more gateways 106a...106n. A manufacturing facility may have one or more gateways 106a...106n. In some embodiments, a gateway may be a computing device configured to communicate with one or more WBMS nodes. For example, the gateway may be configured to communicate with the WBMS node(s) through a local communication network (e.g., a local WiFi network).

In some embodiments, any suitable number of gateways 106a...106n may be provided for monitoring the fleet of batteries represented by the WBMS nodes 104a...104n. Tens of gateways, hundreds of gateways, or thousands of gateways may be provided. Multiple gateways may be placed at a same location, or within the same vicinity, such as within a same building, room, or transportation vehicle. Each gateway may aggregate data from a plurality of the WBMS nodes 104a...104n, such as from tens, hundreds, or thousands of WBMS nodes.

The gateways 106a...106n may communicate with the WBMS nodes 104a...104n and the data aggregation and management module 108 using any suitable protocol. In some embodiments, the gateways may be 4G and/or 5G enabled, and may communicate according to the wireless 4G and/or 5G standards. However, the aspects of the present application involving gateways to communicate with WBMS nodes and a data aggregation and management module are not limited to communicating according to any particular protocol. FIGs. 3 and 4 illustrate non-limiting examples of communication between a WBMS node and a gateway.

FIG. 3 illustrates a subsystem 300 comprising a WBMS node 304 and a gateway 306. The WBMS node 304 comprises a battery pack 305 and a battery monitor 307 (e.g., a dongle) including an antenna 309. The battery pack 305 may be of the types described previously herein, or may be any other battery pack for which it is desired to monitor a condition of the battery pack. The battery monitor 307 may include a sensor configured to sense a condition of the battery pack 305. For example, the battery monitor 307 may include a sensor configured to sense voltage, current, state of charge, temperature chemical composition, or any other condition of the battery pack for which it is desired to collect data. In some embodiments, the sensor may be connected to sense wires of a battery pack through which the sensor may perform measurements (e.g., voltage measurements) of individual cells of the battery pack. In some embodiments, the sensor may include a spectrometer, ultrasound imager, or RADAR imager.

The battery monitor 307 may be attached to the battery pack 305 in any suitable manner, such as being clipped to the battery terminals, screwed to a housing of the battery pack, or connected in any other manner. The battery monitor 307 may be removable, so that it can attached to a different battery pack when desired. The battery monitor 307 may allow for delivery of more sophisticated measurement and sensing techniques suitable for warehouse and transport storage, that may be too expensive to integrate into every battery. A non-limiting example of such measurement and sending techniques may include impedance spectroscopy with edge processing/modelling. The antenna 309, which may be part of the battery monitor 307, including being integrated in a package of the battery monitor 307, may communicate wirelessly with the gateway 306. In some embodiments, the battery monitor 307 may include a processor and memory. The memory may store instructions that, when executed by the processor, cause the processor to execute instructions (e.g., of a software application). The battery monitor 307 may thus be programmed to perform a software application (e.g., to perform measurements on the battery pack 305 and/or battery cells therein).

The battery monitor 307 may be configured to perform measurements on the battery pack 305. The battery monitor 307 may be configured to obtain, using a voltage sensor of the battery monitor 307, voltage measurements of a battery cell in the battery pack 305. The battery monitor 307 may be configured to obtain voltage measurements of the battery cell while the battery cell is in a recovery state. In some embodiments, the battery monitor 307 may be configured to apply a stimulus pattern to the battery pack 305. The stimulus pattern may include time periods in which current is being discharged from the battery pack 305 and time periods in which the battery pack 305 is in a recovery state. A time period in which the battery is in a recovery state may be referred to as a "recovery period" and a time period in which current is being discharged may be referred to as a "discharge period". The battery monitor 307 may be configured to obtain measurements (e.g., voltage measurements) of battery cells of the battery pack 305 during both discharge and recovery periods. The stimulus pattern may include varying time period lengths. For example, the stimulus pattern may include a sequence of time periods with decreasing length. In some embodiments, the stimulus pattern may include a sequence of alternating discharge and recovery periods.

In some embodiments, the battery monitor 307 may include a discharge circuit for use in discharging current from the battery pack 305. In some embodiments, the discharge circuit may include a resistor that draws current from the battery pack 305. For example, the discharge circuit may comprise a bleed resistor. The battery monitor 307 may be configured to use the discharge circuit to apply a stimulus pattern to the battery pack 305. For example, the battery monitor 307 may be configured to connect and disconnect the battery pack 305 to the discharge circuit to alternate between discharge and recovery periods. In some embodiments, the battery monitor 307 may include a charging circuit. The battery monitor 307 may use the charging circuit to provide a charging current to the battery pack 305. For example, the charging circuit may include a current source that generates a current to be used to charge cells in the battery pack 305.

In some embodiments, the battery monitor 307 may include wireless communication circuitry. The battery monitor 307 may be configured to use the wireless communication circuitry to communicate with a gateway and/or other battery monitors. In some embodiments, the wireless communication circuitry may be a radio transceiver that allows the battery monitor 307 to communicate with one or more devices within a range of the battery monitor 307. The wireless communication circuitry may be configured to communicate in a local network. In some embodiments, the wireless communication circuitry may be configured to transmit and receive data in packets (e.g., network packets). For example, the wireless communication circuitry may transmit and receive data over one or more radio frequencies.

The gateway 306 may be the type of gateway described previously in connection with FIG. 1. The gateway 306 may include an antenna 310. The antenna 310 may send signals to and receive signals from the WBMS node 304. Specifically, signals may be communicated wirelessly between the antenna 309 and the antenna 310.

FIG. 4 illustrates an alternative subsystem to that of FIG. 3. FIG. 4 illustrates a subsystem 400 comprising a WBMS node 404 and the gateway 306. The gateway 306 has been described previously in connection with FIG. 3, and thus is not described in detail now. The WBMS node 404 includes a battery pack 405 having an integrated battery monitor 407. The integrated battery monitor 407 may include sensors described previously herein. The integrated battery monitor 407 may include integrated wireless communication circuitry for communicating wirelessly with the antenna 310 of the gateway 306. The battery monitor 407 may be battery monitor 307 described herein with reference to FIG. 3.

Battery fleets may include multiple types of WBMS nodes. For example, a battery fleet may include WBMS nodes 304 and WBMS nodes 404. Gateways may be configured to communicate with multiple such types of WBMS nodes. For example, a gateway may be configured to communicate with WBMS node 304 and WBMS node 404.

It should be appreciated from FIGs. 3 and 4 that according to an aspect of the present application, a wireless battery monitor is provided. The wireless battery monitor may be affixed to a battery in an operational or non-operational state, and may collect information about desired characteristics of the battery. In some embodiments, the wireless battery monitor may be a dongle. Some embodiments of the technology described herein may be implemented using the wireless battery monitor. In some embodiments, the wireless sensor is an integrated part of the battery. The type of monitoring done by the wireless sensor may be controlled wirelessly, and may change over time, as described further below.

In some embodiments, wireless enabled batteries may have all the functionality already included in the battery and the battery monitoring service may select the right edge models, optimize the edge measurement techniques and constantly refine the existing models. Such operation may be particularly beneficial if the data being analyzed includes data from earlier parts of the lifecycle, like battery formation. The same techniques may be used in the separate dongle embodiment as well.

Returning to FIG. 1, the battery management system 100 comprises the data aggregation and management module 108. As described previously, the data aggregation and management module 108 implements a BLIS service 110 and maintains a battery database 112. The BLIS service 110, which may be executed in the Cloud or in some embodiments may alternatively be executed on a private network, or may be implemented in other manners, may serve as an aggregation point for data collected from the WBMS nodes, may provide a user interface, may maintain digital twins of the monitored batteries, may serve as a marketplace for batteries, and may serve as a source of development and deployment of battery models. Those functions are described in further detail below. The battery database 112 may store data of the type collected from the WBMS nodes, as well as additional data that may be useful in the performance of the functions handled by the BLIS Cloud service 110. For example, as shown in FIG. 1, the battery database 112 may include tables 114 storing information such as a battery pack identification ("pack ID"), a battery module identification ("module ID"), battery cell identification ("cell ID"), voltage, current, temperature, and date information. For example, each measurement of voltage, current, and/or temperature may be time stamped. Those measurements may be taken at various times, and information related to the measurements over time may be stored in the battery database 112. Additional or alternative information may be maintained as desired. Such information may be sent to the BLIS service 110 by the WBMS nodes (e.g., WBMS nodes 104a...104n).

In some embodiments, the battery database 112 may include one or more storage devices storing data in one or more formats. In some embodiments, the battery database 112 may include one or multiple storage devices storing data in one or more formats of any suitable type. For example, the storage device(s) part of a data store may store data using one or more database tables, spreadsheet files, flat text files, and/or files in any other suitable format (e.g., a native format of a mainframe). The storage device(s) may be of any suitable type and may include one or more servers, one or more database systems, one or more portable storage devices, one or more non-volatile storage devices, one or more volatile storage devices, and/or any other device(s) configured to store data electronically. In embodiments where a data store includes multiple storage devices, the storage devices may be co-located in one physical location (e.g., in one building) or distributed across multiple physical locations (e.g., in multiple buildings, in different cities, states, or countries). The storage devices may be configured to communicate with one another using one or more networks of any suitable type, as aspects of the technology described herein are not limited in this respect.

In some embodiments, the BLIS service 110 may be configured to generate a characterization of a battery cell. The BLIS service 110 may be configured to generate a characterization of battery cell using measurement data obtained by a battery monitor (e.g., voltage measurements of the battery cell during application of a stimulus pattern). In some embodiments, the characterization of the battery cell may be an impedance of the battery cell. For example, the characterization of the battery cell may be a complex impedance of the battery cell. In another example, the characterization of the battery cell may be an impedance of the battery cell at various electrical signal frequencies.

In some embodiments, the BLIS service 110 may be configured to match battery cells using characterizations generated for the battery cells. The BLIS service 110 may be configured to determine a measure of similarity between characterizations of the battery cells. The BLIS service 110 may match battery cells based on the measure of similarity. For example, the BLIS service 110 may match battery cells based on similarity of impedances of the battery cells. The matched battery cells may be coupled in a battery pack.

In some embodiments, the BLIS service 110 may be configured to verify an authenticity of a battery cell. The BLIS service 110 may be configured to use a characterization of the battery cell to verify the authenticity of the battery cell. For example, the BLIS service 110 may use the characterization to verify that the battery cell is one approved for use in the battery pack (e.g., from an approved manufacturer). The BLIS service 110 may be configured to use the characterization of the battery cell to verify operation of the battery cell. For example, the BLIS service 110 may use the characterization of the battery cell to verify that there are no defects or faults in the battery cell.

Although example embodiments described herein may be implemented by the BLIS service 110. Some embodiments may be implemented on a gateway (e.g., gateways 106a...n). For example, generation of a battery characterization, battery matching, and/or verification of authenticity of a battery cell may be performed by a gateway in addition to or instead of the BLIS service 110.

As has been described the battery management system 100 may be used to monitor batteries through any and all stages of their lifecycle. FIG. 5 illustrates a non-limiting example. The method 500 illustrates monitoring of a battery cell, module, or pack through its lifecycle. As shown at stage 502, the battery may be manufactured. At this stage, monitoring 503 may be performed. The monitoring may include detecting SOH, SOC, or any other desirable parameter, including any of those described previously herein. The monitoring may include performing measurements on the battery. Example techniques of performing measurements are described herein.

At stage 504 the battery may be stored in a storage facility. For example, the battery may be put in a warehouse for subsequent deployment. At this stage, monitoring 505 may occur. As with the other monitoring stages of method 500, monitoring stage 507 may entail monitoring any parameter of interest.

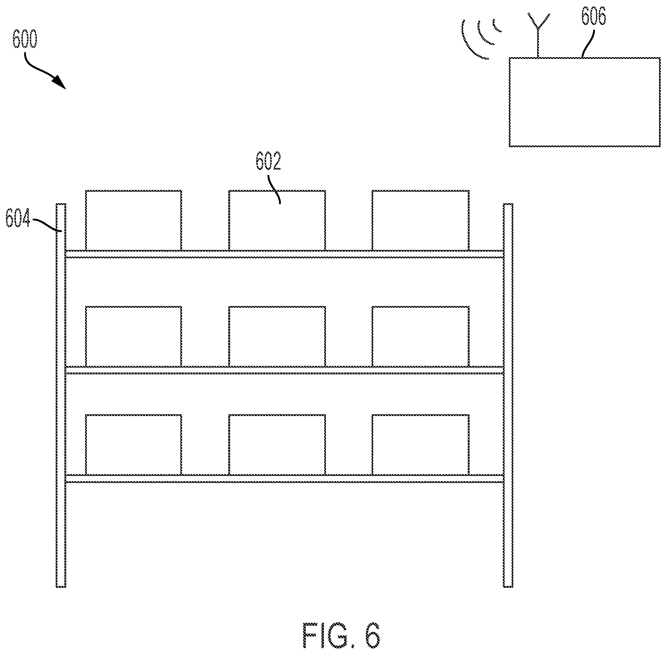

An example of a configuration for monitoring a battery in storage is shown in FIG. 6. The monitoring setup 600 comprises a plurality of batteries 602 on a shelf 604, and a gateway 606. The battery 602 may be a WBMS node, such as any of the WBMS nodes described previously herein. The shelf 604 may be in a warehouse, or other storage location. Any number of batteries 602 may be stored on the shelf, waiting for deployment. The gateway 606 may be any of the types of gateways described previously herein. The gateway may communicate wirelessly with all the batteries on the shelf 604, or with a subset of them, collecting data from the batteries which may be passed to a BLIS service, such as described previously in connection with FIG. 1. Such monitoring and data collection may occur at any suitable time interval.

Returning to FIG. 5, at stage 506, the battery may be deployed in its first life. For example, the battery may be commissioned for use in a ship, or an electric vehicle. At this stage, monitoring 507 may be performed. As with the other monitoring stages of method 500, monitoring stage 507 may entail monitoring any parameter of interest.

After deployment at stage 506, the battery may be decommissioned and placed back in storage at stage 508. For example, the battery may be returned to a warehouse or other storage facility. At this stage, monitoring 509 may occur. As with the other monitoring stages of method 500, monitoring stage 507 may entail monitoring any parameter of interest.

At stage 510, the battery may be reused, for example in its second life. For example, the battery may be commissioned for a new use from that of stage 506. As an illustrative example, the battery may have been used to power an electric vehicle in its first life. In its second life, the battery may be used to power a wind turbine. At this stage, monitoring 511 may be performed. As with the other monitoring stages of method 500, monitoring stage 511 may entail monitoring any parameter of interest.

The method 500 may involve iterating between use of the battery and storage of the battery, as shown by the arrow from stage 510 to 508. Batteries may have multiple lives, being repurposed multiple times. The battery management system described herein may monitoring the batteries throughout such a lifecycle.

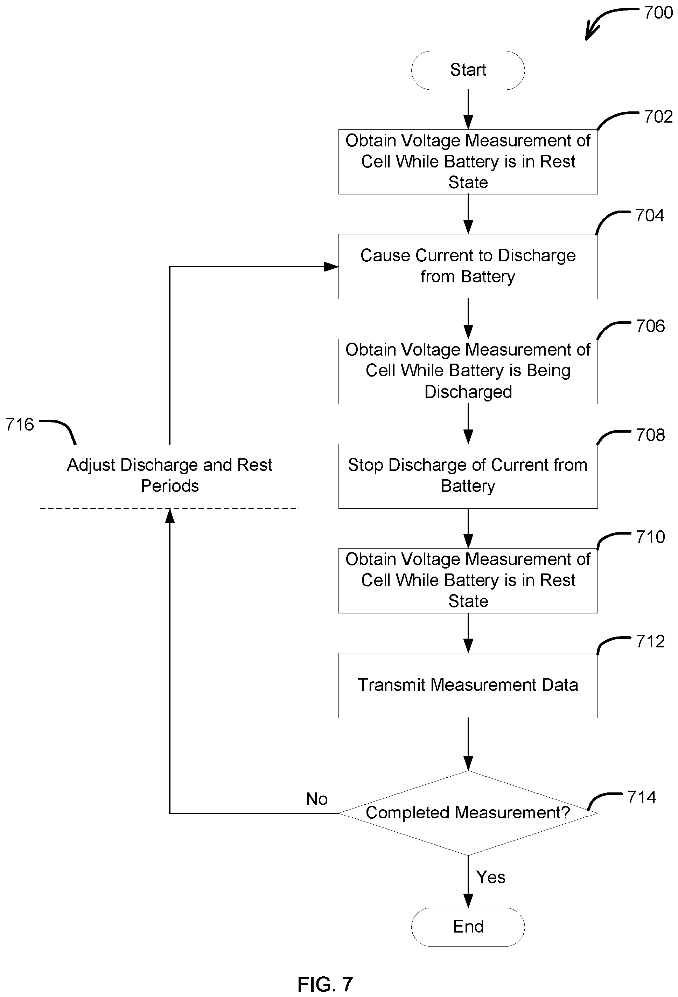

FIG. 7 illustrates an example method 700 of performing a measurement on a battery, according to some embodiments of the technology described herein. The method 700 may be performed by a battery monitor (e.g., battery monitor 307). In some embodiments, the method 700 may be performed as part of the monitoring at stages 503, 505, 507, 509, 511 of method 500 described herein with reference to FIG. 5.

Method 700 begins at stage 702, at which the system obtains a voltage measurement of a cell of a battery while the battery is in a rest state. A rest state may be a period of time in which no stimulus is applied to the battery and there is no change in voltage perceptible by a voltage sensor. In some embodiments, the system may be configured to obtain the voltage measurement after the battery has been in a rest state for a threshold period of time. For example, the system may obtain the voltage measurement after the battery has been in a rest state for 1 hour, 2 hours, 3 hours, 4 hours, 5 hours, 6 hours, 7 hours, 8 hours, 9 hours, 10 hours, 11 hours, 12 hours, or 1 day. In some embodiments, the system may be configured to obtain the voltage measurement after the battery has been in at a stable temperature. For example, the system may obtain voltage measurement after the temperature does not change by more than a threshold amount (e.g., 0.5 degrees, 1 degree, 1.5 degrees, 2 degrees, 2.5 degrees, or 3 degrees Celsius) for a minimum period of time (e.g., 1 minute, 2 minutes, 3 minutes, 4 minutes, 5 minutes, 10 minutes, 30 minutes, 1 hour, 2 hours, 3 hours, 4 hours, 5 hours, 6 hours).

The system may be configured to obtain the voltage measurement of the cell in any suitable way. In some embodiments, the system may be configured to obtain the voltage measurement by measuring the voltage of the cell at multiple time intervals. For example, the system may measure the voltage of the cell every 1 milliseconds (ms), 10 ms, 100 ms, 1000 ms, 10000 ms, or other interval between these intervals. In some embodiments, the system may be configured to measure the voltage of the cell one or multiple times in each time interval. For example, the system may measure the voltage of the cell 1 time, 2 times, 3 times, 4 times, 5 times, 6 times, 7 times, 8 times, 9 times, 10 times, 11 times, or 12 times during each time interval. In some embodiments, the voltage measurement may be a mean or median of multiple voltage measurements. For example, the system may: (1) obtain multiple voltage measurements; and (2) determine a mean or median of the multiple voltage measurements.

Next, method 700 proceeds to stage 704, at which the system causes the current to discharge from the battery. The system may be configured to cause the current to discharge from the battery by connecting discharge circuitry to the battery. For example, the circuitry may include a resistor that, when electrically connected to the battery, causes current to be discharged from the battery. In some embodiments, the circuitry may include a bleed resistor. The system may be configured to cause current to discharge from the battery by connecting the bleed resistor to the battery. The bleed resistor may thus draw current from the battery. The system may be configured to cause a current of approximately 10 mA, 50 mA, 100 mA, 150 mA, 200 mA, 250 mA, 300 mA, 350 mA, or 400 mA to be discharged from the battery.

In some embodiments, the system may be configured to cause the current to be discharged from the battery for a first period of time. The first period of time may also be referred to as "discharge period". For example, the system may cause the current to be discharged for a first period of time of 1 second, 5 seconds, 10 seconds, 20 seconds, 30 seconds, 1 minute, 5 minutes, 10 minutes, 15 minutes, or 20 minutes.

Next, method 700 proceeds to stage 706, at which the system obtains a voltage measurement of the cell while the battery is being discharged. The system may be configured to obtain the voltage measurement as described at stage 702. For example, the system may measure the voltage of the cell at multiple time intervals, and may measure the voltage of the cell one or multiple times in each time interval.

Next, method 700 proceeds to stage 708, at which the system stops discharge of current from the battery. In some embodiments, the system may be configured to stop the discharge of current by disconnecting a discharge circuit from the battery. For example, the system may stop the discharge of current by disconnecting a bleed resistor from the battery. By stopping discharge of current from the battery, the system may cause the battery to enter a recovery state. In some embodiments, the system may be configured to stop discharge of current from the battery for a second period of time in which the battery is in a recovery state. For example, the system may stop discharge of the current for a second period of time of 1 second, 5 seconds, 10 seconds, 20 seconds, 30 seconds, 1 minute, 5 minutes, 10 minutes, 15 minutes, or 20 minutes. In some embodiments, the recovery period of time may be the same as the discharge period of time that current was discharged from the battery. In some embodiments, the recovery period may be different from the discharge period.

Next, method 700 proceeds to stage 710, at which the system obtains a voltage measurement of the cell while the battery is in the recovery state. The system may be configured to obtain the voltage measurement as described at stage 702. For example, the system may measure the voltage of the cell at multiple time intervals, and may measure the voltage of the cell one or multiple times in each time interval.

In some embodiments, the system may be configured to determine information in addition to voltage measurements of the cell. In some embodiments, the system may be configured to log, for each measured voltage value, whether the battery was being discharged or in recovery during the measurement. In some embodiments, the system may be configured to measure an ambient temperature (e.g., of a battery monitor) measured during each measured voltage value. The system may be configured to log the measured ambient temperature for each voltage measurement.

Next, method 700 proceeds to stage 712, at which the system transmits measurement data. In some embodiments, the system may be configured to transmit the measurement data as it is being obtained. The system may be configured to transmit the measurement data at regular time intervals. For example, the system may transmit measurement data every 1 milliseconds (ms), 10 ms, 100 ms, 1000 ms, 10000 ms, or other suitable interval. The transmission after each time interval may include voltage measurement(s) of the cell measured during the time interval. For example, the voltage measurement(s) may be multiple voltage values measured during the interval. In another example, the voltage measurement(s) may be a mean or median or multiple voltage values measured during the interval. In some embodiments, the system may be configured to transmit measurement data while measurement is being performed. For example, the system may transmit the measurement data during stage 706 and/or 710. In some embodiments, the system may be configured to transmit measurement data after measurement is completed. For example, the system may transmit the measurement data after completing stages 706 and/or 710. In some embodiments, the measurement data may include information in addition to voltage measurements. For example, the measurement data may include time information (e.g., timestamps of voltage measurements), an indication of whether the voltage measurement was taken during discharge or in a recovery state, a stack voltage measurement summing measured voltages of all the cells of a battery pack, temperature, and/or other information.

The system may be configured to transmit the measurement data to a computing device. In some embodiments, the system may be configured to transmit the measurement data to a gateway described herein with reference to FIG. 1. As an illustrative example, the system may transmit the measurement data to the gateway through a communication network (e.g., a local WiFi network). In some embodiments, the system may be configured to transmit the measurement data to a BLIS service described herein with reference to FIG. 1. For example, the system may transmit the measurement data to the BLIS service through a communication network (e.g., the Internet) using wireless communication circuitry (e.g., a transceiver).

Next, method 700 proceeds to stage 714, at which the system determines if measurements have been completed. In some embodiments, the system may be configured to determine whether measurement has been completed based on whether a stimulus pattern has been completed. A stimulus pattern may comprise a sequence of discharge and recovery time periods. For example, a stimulus pattern may consist of alternating discharge and recovery time periods. In some embodiments, the stimulus pattern may include multiple pairs of discharge and recovery time periods, where the lengths of the discharge and recovery time periods of each pair are the same. As an illustrative example, a stimulus pattern may be as follows: (1) discharge period of 10 minutes; (2) recovery period of 10 minutes; (3) discharge period of 5 minutes; (4) recovery period of 5 minutes; (5) discharge period of 1 minute; (6) recovery period of 1 minute; (7) discharge period of 30 seconds; (8) recovery period of 30 seconds; (9) discharge period of 10 seconds; (10) recovery period of 10 seconds; (11) discharge period of 5 seconds; (12) recovery period of 5 seconds; (13) discharge period of 1 second; and (14) recovery period of 1 second.

If at stage 714 the system determines that the measurement is complete, then method 700 ends. If at stage 714, the system determines that the measurement is not completed (e.g., the stimulus pattern has not been completed), then method 700 proceeds to stage 716, at which the system adjusts discharge and recovery periods used to obtain the voltage measurements. For example, the system may have performed (1) and (2) in the above-described stimulus pattern in which the battery was discharged for 10 minutes and then at recovery for 10 minutes, and then adjusts the discharge and recovery periods to be 5 minutes at stage 716. The system may then perform stages 704 to 714 using the adjusted discharge and recovery times. As indicated by the dotted line of stage 716, in some embodiments, the system may proceed to stage 704 without adjusting the discharge and recovery periods. For example, the system may perform stages 704-714 using the same discharge and recovery periods as used in a previous iteration.

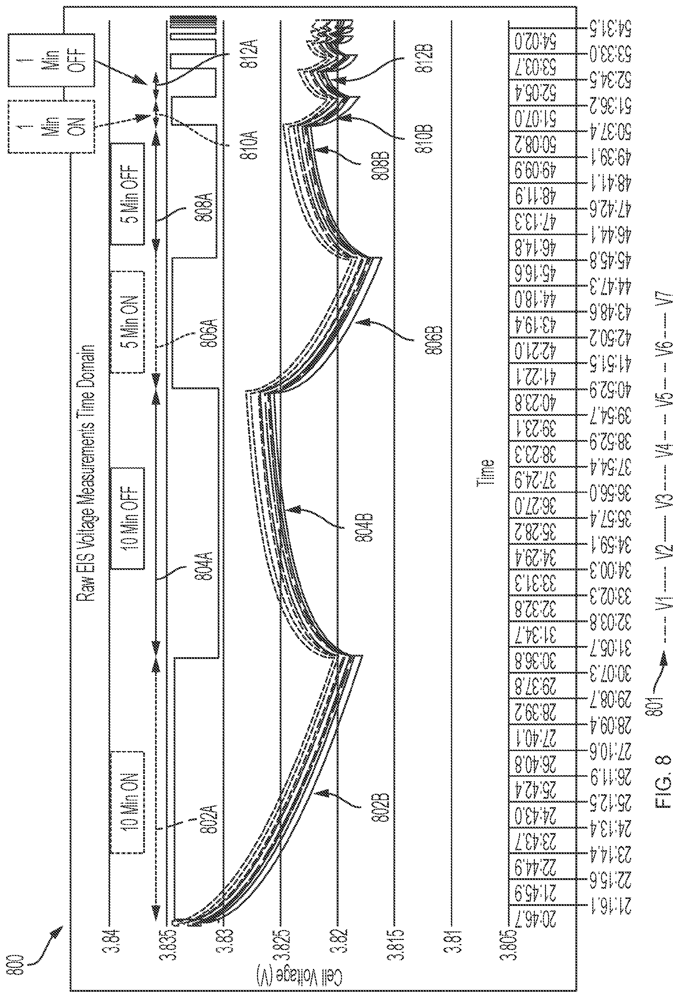

FIG. 8 illustrates an example plot 800 of data collected from performing a measurement on a battery, according to some embodiments of the technology described herein. For example, the data shown in plot 800 may be obtained from performing method 700 described herein with reference to FIG. 7. The plot 800 shows voltage measurements for a set of battery cells 801. The voltage measurements include voltage values 802B measured during a discharge period 802A of 10 minutes, voltage values 804B measured during a recovery period of 10 minutes, voltage values 806B measured during a discharge period 806A of 5 minutes, voltage values 808B measured during a recovery period 808A of 5 minutes, voltage values 810B measured during a discharge period 810A of 1 minute, and voltage values 812B measured during a recovery period 812A of 1 minutes. The discharge and recovery period sequence shown in plot 800 may be all or a portion of a stimulus pattern used to perform method 700.

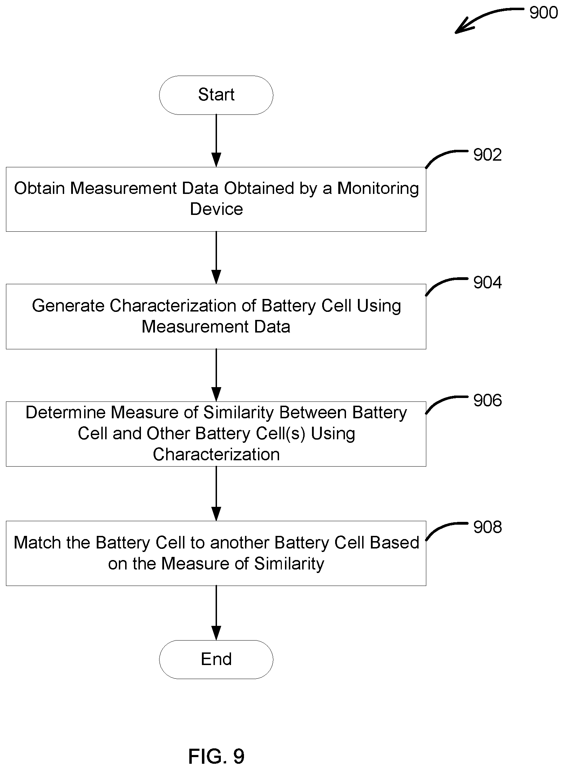

In some embodiments, measurements obtained from performing process 700 may be used for various purposes. In some embodiments, the measurements may be used to generate a characterization of the battery cell (e.g., as described at stage 904 of process 900 described herein with reference to FIG. 9). For example, the measurements may be used to determine an impedance (e.g., complex impedance) of a battery cell. In some embodiments, the measurements obtained for different battery cells may be used to sort the battery cells (e.g., using respective characterizations generated using the measurements). In some embodiments, the measurements may be used to identify an outlier. For example, the measurements may indicate that a battery cell is an outlier from among a set of battery cells (e.g., due to being more than 1, 2, 3, 4, or 5 standard deviations from a median measurement). In some embodiments, the measurements may be used to determine a state of health of a battery cell. For example, the measurements may be used to determine whether the battery cell is operational or defective. In some embodiments, the measurements may be used to determine a state of charge of the battery cell. In some embodiments, the measurements may be used to determine a temperature of the battery cell.

FIG. 9 illustrates an example method 900 of matching a battery cell to another battery cell, according to some embodiments of the technology described herein. Method 900 may be performed by any suitable computing device. For example, method 900 may be performed by BLIS 110 described herein with reference to FIG. 1 (e.g., using measurement data obtained by performing method 700).

Method 900 begins at stage 902, where the system performing method 900 obtains measurement data for a battery cell obtained by a battery monitor. in some embodiments, the measurement data may be obtained by a battery monitor. The measurement data may be obtained by the battery monitor by performing method 700 described herein with reference to FIG. 7. An example of measurement data is illustrated in FIG. 8.

At stage 904, the system generates a characterization of the battery cell using the measurement data. In some embodiments, the system may be configured to generate the characterization of the battery cell to be an impedance of the battery cell. The system may be configured to determine the impedance of the battery cell using measured voltage values. For example, the system may use the voltage values in conjunction with current values determined using a bleed resistor to determine the impedance of the battery cell. In some embodiments, the impedance may be one or more complex values. In some embodiments, the system may be configured to determine the impedance at various electrical signal frequencies.

At stage 906, the system determines a measure of similarity between the battery cell and one or more other battery cells using the characterization. The system may be configured to determine the measure of similarity by comparing the characterization of the battery cell to characterization(s) generated for the other battery cell(s) (e.g., using measurement data obtained for the other battery cell(s)). In some embodiments, the system may be configured to determine the measure of similarity between two battery cells to be a measure of difference between impedances of the battery cells. For example, the system may determine a magnitude of a difference between complex impedance values of the two battery cells. A lower measure of difference may indicate that the battery cells are more similar. A higher measure of difference may indicate that the battery cells are less similar.

At stage 908, the system matches the battery cell to another battery cell based on the measure of similarity. In some embodiments, the system may be configured to determine whether the battery cell is similar to another battery cell if the measure of similarity between the two battery cells meets a threshold measure of similarity. For example, if the measure of difference in impedance of the two battery cells is sufficiently small, the system may determine to match the battery cells. In some embodiments, the system may use the measures of similarities between the battery cell and a set of battery cells to identify one or more of the set of battery cells that match the battery cell. The system may be configured to select one or more of the set of battery cells that are the most similar to the battery cell using the measures of similarity. For example, the system may be configured to select one or more battery cells from the set of battery cells that have the lowest difference in impedance from the battery cell.

In some instances, the system may determine that the battery cell may not be matched to another battery cell. The system may determine that the battery cell is not sufficiently similar to another set of battery cells to be included in a battery pack with the set of battery cells. In this case, the system may determine to not match the battery cell with another battery cell. The battery cell may be a candidate for being matched to another battery cell at a later time.

After stage 908, method 900 ends. The matching result obtained at stage 908 may be used, for example, to match one battery cell with another. The matched battery cells may be included together in a battery pack. The battery pack may then be assembled to include the matched battery cells.

In some embodiments, the system may operate as a battery matching service, where the system creates a battery pack to recommend to a user (e.g., a customer). In some embodiments, the system may determine a combination of modules and/or cells to create a battery pack. The system may use data collected from a fleet of batteries to create the battery pack. The created battery pack may then be used to provide a battery pack to a user. For example, the determined battery pack may be used to draw cells, modules, and/or battery packs from inventory, and used in assembly of the battery pack. The created battery pack may also be used to build an inventory of battery packs, modules, and/or cells to be held in inventory to subsequently provide the created battery pack to the user.

In some embodiments, the system may operate the battery matching service to facilitate maintenance of battery packs. If the system determines that a WBMS node does not meet a quality criterion (e.g., of health or performance), the system may match a battery pack to the node and trigger dispatch of the battery pack to a geographic location at which a current battery pack of the node can be replaced (e.g., a service center). A battery pack at the node may then be replaced with the dispatched battery pack. In some embodiments, the system may predict that a node will fail to meet a quality criterion and trigger a dispatch based on the predicted failure. For example, the system may use a digital twin to predict a failure and trigger dispatch of a battery pack based on the predicted failure.

In some embodiments, the system may be configured to operate as a battery matching service for maintenance and battery pack creation scenarios. The system may be configured to recommend the best combinations of modules and cells to create a battery pack by looking at the data across a broad fleet of batteries. This information can then be used to draw batteries from inventory and order them for the production line to create optimal performing battery packs while also minimizing production time by ensuring the right cells and modules are available on the production line at the right time. In addition, it can be used to ascertain that the correct cells and modules were combined. It will continue monitoring of the created module or pack as it returns to inventory. The system may identify the most compatible modules or cells for a battery pack and this information can be used to build an inventory of replacement parts, allowing specific modules or cells to be held in reserve to match a population of battery packs in the field. This may help ensure that a healthy population of compatible replacement parts are always in inventory. The same matching algorithm can be used throughout the lifecycle of the battery pack to facilitate maintenance of battery packs.

In some embodiments, if a module is detected as failing or underperforming, the system may be configured to find a match and dispatch it to a geographical location such as a service center where the battery can be updated with a matching module. The system may make the decision on where to dispatch the battery to by virtue of location information provided as an additional input from another system. The system may also predict potential failures if operational data is ingested through an integration interface and the model for the cell, module or pack is further refined.

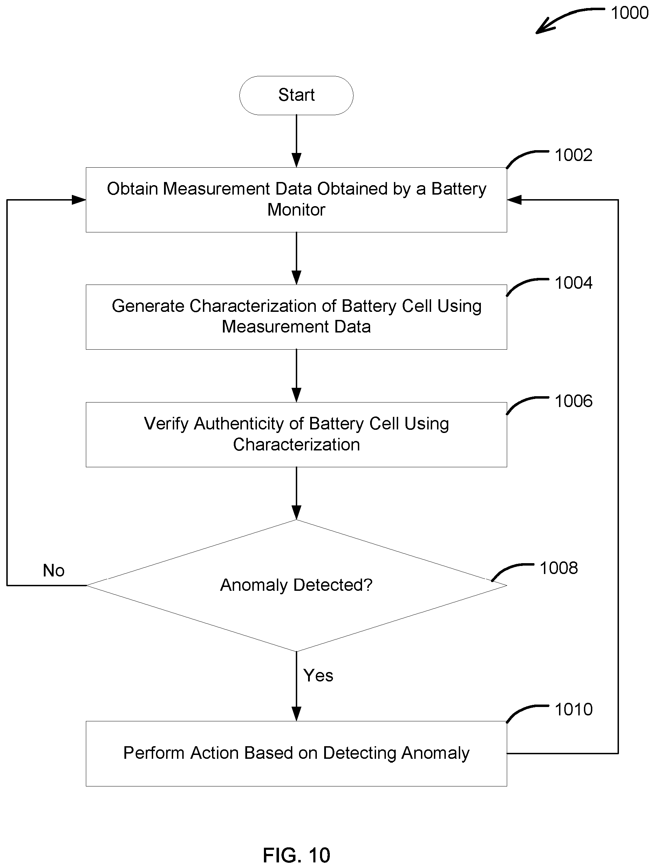

FIG. 10 illustrates an example method 1000 of verifying authenticity of a battery cell, according to some embodiments of the technology described herein. Method 1000 may be performed by a gateway and/or BLIS described herein with reference to FIG. 1. For example, method 1000 may be performed to verify that a battery cell in a battery pack is one manufactured by an approved manufacturer, to verify that the battery cell is not a counterfeit, or to otherwise determine if there is a defect in the battery cell.

Method 1000 begins at stage 1002, where the system obtains measurement data obtained by a battery monitor. The measurement data may be obtained by the battery monitor by performing method 700 described herein with reference to FIG. 7.

At stage 1004, the system generates a characterization of the battery cell using the measurement data. The system may be configured to generate the characterization of the battery cell as described at stage 904 of method 900 described herein with reference to FIG. 9. For example, the system may generate the characterization of the battery cell to be an impedance of the battery cell determined using the measurement data.

At stage 1006, the system verifies the authenticity of the battery cell using the characterization. In some embodiments, the system may be configured to verify the authenticity of the battery cell by comparing the characterization of the battery cell to an expected characterization. For example, the system may compare an impedance of the battery cell determined from the measurement data to an expected impedance of the battery cell. In some embodiments, the expected characterization may be generated using data from other battery cells of the same model. For example, the system may determine a mean or median impedance of battery cells of the model to be the expected impedance. In some embodiments, the expected characterization may be generated from measurements previously performed on the battery cell. For example, the expected characterization may be a characterization that was previously generated using measurement data. In some embodiments, the expected characterization may be determined from a specification of the battery cell. For example, a manufacturer of the battery cell may provide information indicating an expected characterization of the battery cell.

At stage 1008, the system determines whether an anomaly is detected. The system may be configured to determine whether there is an anomaly by comparing the characterization generated at stage 1004 to the expected characterization. In some embodiments, the system may be configured to determine a measure of difference between the generated characterization and the expected characterization. For example, the system may determine a magnitude of difference between a determined impedance and an expected impedance of the battery cell. The system may determine that there is an anomaly when the magnitude of the difference is greater than a threshold.

In some embodiments, the system may be configured to identify a cause of the anomaly. The system may be configured to analyze the difference between the generated characterization and the expected characterization to identify the cause of the anomaly. For example, the system may determine the cause of the anomaly based on particular operating regions in which the impedances differ by greater than a threshold amount.

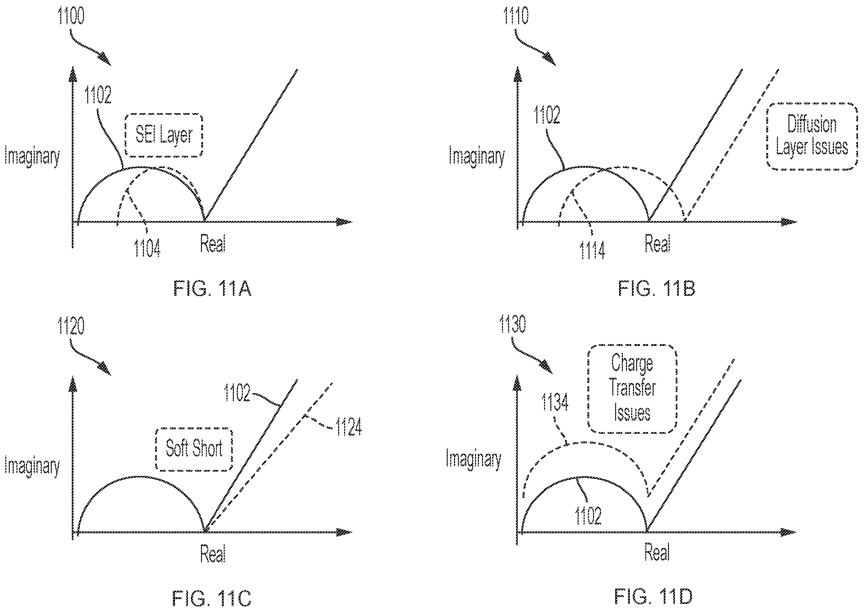

FIGs. 11A-11D illustrate example Nyquist plots of impedances of a battery cell generated using measurement data and expected impedances of the battery cell, according to some embodiments of the technology described herein. Each of the plots 1100, 1110, 1120, 1130 illustrated in FIGs. 11A-11D show a plot of an expected impedance 1102 of the battery cell. Plot 1100 of FIG. 11A shows a plot of an impedance 1104 generated using measurement data. In the example of FIG. 11A, the system may determine that the deviation from the expected impedance 1102 is due to an issue in the solid electrolyte interphase (SEI) layer of the battery cell. Plot 1110 of FIG. 11B shows a plot of an impedance 1114 generated using measurement data. In the example of FIG. 11B, the system may determine that the deviation from the expected impedance 1102 is due to an issue with a diffusion layer of the battery cell. Plot 1120 of FIG. 11C shows a plot of impedance 1124 generated using measurement data. In the example of FIG. 11C, the system may determine that the deviation from the expected impedance 1102 is due to a soft short in the battery cell. Plot 1130 of FIG. 11D shows a plot of impedance 1132 generated using the measurement data. In the example of FIG. 11D, the system may determine that the deviation from the expected impedance 1102 is due to a charge transfer issue in the battery cell.

If at stage 1008 the system detects an anomaly (e.g., identified based on a deviation from an expected characterization), the method 1000 proceeds to stage 1010, at which the system performs an action based on the detected anomaly. In some embodiments, the system may be configured to generate an alert indicating the detected anomaly. For example, the system may generate a graphical user interface (GUI) element in a GUI indicating the detected anomaly (e.g., SEI layer issue, soft short, charge transfer issue, or issue with a diffusion layer of the battery). In another example, the system may generate an alert that the battery cell is a counterfeit. In another example, the system may generate an alert indicating that the battery cell is defective. In some embodiments, the system may be configured to determine corrective action to be taken based on the detected anomaly. For example, the system may determine whether the battery cell is to be replaced, repaired, or otherwise removed from further use.

If at stage 1008 the system determines that there is no anomaly, then method 1000 may proceed to stage 1002, where the system obtains measurement data obtained by a battery monitory (e.g., at a subsequent time). In some embodiments, the system may be configured to periodically perform method 1000 to continuously monitor a battery cell. The method 1000 may thus allow monitoring of the battery cell throughout its lifecycle. For example, method 1000 may be performed at stage 503, 505, 507, 509, or 511 of method 500 described herein with reference to FIG. 5.

It should be appreciated that the various functions described herein may be performed by a suitable processor configuration. For example, the WBMS nodes, gateways, and BLIS may, and in at least some embodiments do, each include at least one processor. The at least one processor executes processor-executable instructions to perform the functions of those items. For example, BLIS service 110 in some embodiments is implement by a plurality of processors (at least one processor) that execute processor-executable instructions to prompt performance of the functions described herein as being performed by the BLIS service. A storage device, such as one or more memories, including distributed memories, store the processor-executable instructions. If the BLIS service 110 is implemented in the Cloud, suitable combinations of storage devices and processors may be used to perform the described functions.

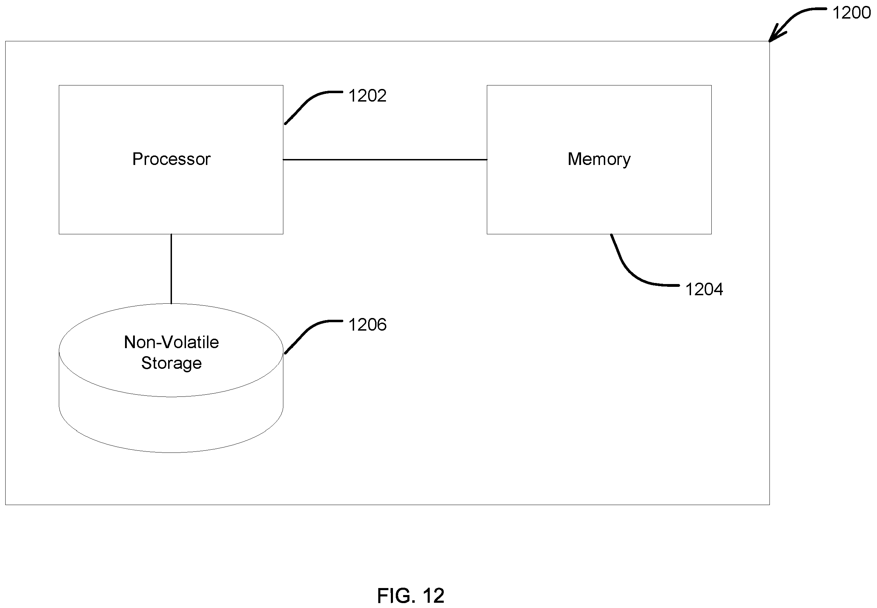

FIG. 12 illustrates an example computer system 1200 which may be used to implement some embodiments of the technology described herein. The computer system 1200 may include one or more computer hardware processors 1202 and non-transitory computer-readable storage media (e.g., memory 1204 and one or more non-volatile storage devices 1206). The processor(s) 1202 may control writing data to and reading data from (1) the memory 1204; and (2) the non-volatile storage device(s) 1206. To perform any of the functionality described herein, the processor(s) 1202 may execute one or more processor-executable instructions stored in one or more non-transitory computer-readable storage media (e.g., the memory 1204), which may serve as non-transitory computer-readable storage media storing processor-executable instructions for execution by the processor(s) 1202.

The terms "approximately" and "about" may be used to mean ±20% of a target value in some embodiments, within ±10% of a target value in some embodiments, within ±5% of a target value in some embodiments, and yet within ±2% of a target value in some embodiments. The terms "approximately" and "about" may include the target value.

## Claims

1. A battery monitor (307) coupled to a battery (305) comprising at least one cell, the at least one cell including a first cell, the battery monitor comprising:
a voltage sensor electrically coupled to the battery (305);
a processor; and
a non-transitory computer-readable storage medium storing instructions that, when executed by the processor, cause the processor to:
cause discharge of current from the battery over a sequence of discharge periods (704), each discharge period followed by a recovery period;
obtain, using the voltage sensor, a first plurality of voltage measurements of the first cell during recovery periods that follow respective discharge periods, the obtaining comprising:
obtaining, using the voltage sensor, at least one first voltage measurement of the first plurality of voltage measurements of the first cell during a first recovery period after a first discharge period (710); and
obtaining, using the voltage sensor, at least one second voltage measurement of the first plurality of voltage measurements of the first cell during a second recovery period after a second discharge period, wherein the second recovery period is subsequent to the first recovery period (710);
wherein the first plurality of voltage measurements of the first cell is used to indicate at least a portion of a first characterization of the first cell (904).

2. The battery monitor (307) of claim 1, wherein the at least one first voltage measurement comprises a plurality of voltage measurements and the instructions further cause the processor to determine a median or mean of the plurality of voltage measurements.

3. The battery monitor (307) of any preceding claim, wherein the at least one first voltage measurement comprises a plurality of voltage measurements obtained at intervals of approximately 16 milliseconds during the first recovery period.

4. The battery monitor (307) of any preceding claim, further comprising a discharge circuit electrically coupled to the battery, wherein the instructions further cause the processor to:
obtain, using the voltage sensor, a second plurality of voltage measurements of the first cell during the sequence of discharge periods;
wherein the second plurality of voltage measurements of the first cell is used to indicate at least a portion of the first characterization of the first cell.

5. The battery monitor (307) of claim 4, wherein the discharge circuit comprises a bleed resistor of the battery.

6. The battery monitor (307) of any preceding claim, wherein a length of the first recovery period is approximately equal to a length of the first discharge period.

7. The battery monitor (307) of any of claims any preceding claim, wherein the instructions further cause the processor to generate:
a first indication that the battery was in recovery during the at least one first voltage measurement.

8. The battery monitor (307) of any preceding claim, wherein obtaining, using the voltage sensor, the first plurality of measurements of the first cell during the plurality of recovery periods further comprises:
obtaining, using the voltage sensor, at least one third voltage measurement of the first plurality of voltage measurements of the first cell during a third recovery period after a third discharge period (710), wherein the third discharge period is subsequent to the second recovery period.

9. The battery monitor of any preceding claim, wherein the second recovery period is shorter than the first recovery period.

10. A method performed by a battery monitor (307) coupled to a battery (305) comprising at least one cell, the at least one cell including a first cell, the method comprising:
causing discharge of current from the battery over a sequence of discharge periods (704), each discharge period followed by a recovery period;
obtaining, using a voltage sensor, a first plurality of voltage measurements of the first cell during recovery periods that follow respective discharge periods, the obtaining comprising:
obtaining, using the voltage sensor, at least one first voltage measurement of the first plurality of voltage measurements of the first cell during a first recovery period (710) after a first discharge period;
obtaining, using the voltage sensor, at least one second voltage measurement of the first plurality of voltage measurements of the first cell during a second recovery period (710) after a second discharge period, wherein the second recovery period is subsequent to the first recovery period;
wherein the first plurality of voltage measurements of the first cell is used to indicate at least a portion of a first characterization of the first cell.

11. The method of claim 10, further comprising obtaining, using the voltage sensor, a second plurality of voltage measurements of the first cell during the sequence of discharge periods (706),
wherein the second plurality of voltage measurements of the first cell is used to indicate at least a portion of the first characterization of the first cell.

12. The method of claim 10 or claim 11, wherein obtaining, using the voltage sensor, the first plurality of measurements of the first cell during the plurality of recovery periods further comprises:
obtaining, using the voltage sensor, at least one third voltage measurement of the first plurality of voltage measurements of the first cell during a third recovery period (710) after a third discharge period, wherein the third discharge period is subsequent to the second recovery period.

13. The battery monitor of any of claims 1-9, wherein the first plurality of voltage measurements of the first cell are used for generating the first characterization for the first cell the generating comprising determining an impedance of the first cell as the first characterization using the first plurality of voltage measurements.

14. The battery monitor of any of claims 1-9 or claim 13, wherein the first cell of the first battery is matched to a second cell of a second battery using the first characterization for the first cell.

15. The battery monitor of any of claims 1-9 or 13-14, wherein an identity of the first cell is verified using the first characterization of the first cell.

## Patentansprüche

1. Batterieüberwachungseinrichtung (307) gekoppelt an eine Batterie (305) umfassend zumindest eine Zelle, die zumindest eine Zelle einschließend eine erste Zelle, die Batterieüberwachungseinrichtung umfassend:
einen Spannungssensor, der elektrisch mit der Batterie (305) gekoppelt ist;
einen Prozessor; und
ein nicht flüchtiges computerlesbares Speichermedium, das Anweisungen speichert, die, wenn sie vom Prozessor ausgeführt werden, den Prozessor veranlassen:
Verursachen einer Entladung des Stroms aus der Batterie über eine Abfolge von Entladungsperioden (704), wobei auf jede Entladungsperiode eine Wiederherstellungsperiode folgt;
Erhalten, unter Verwendung des Spannungssensors, einer ersten Vielzahl von Spannungsmessungen der ersten Zelle während der Wiederherstellungsperiode, die auf die jeweiligen Entladungsperiode folgen, das Erhalten umfassend:
Erhalten, unter Verwendung des Spannungssensors, mindestens einer ersten Spannungsmessung der ersten Vielzahl von Spannungsmessungen der ersten Zelle während einer ersten Wiederherstellungsperiode nach einer ersten Entladungsperiode (710); und
Erhalten, unter Verwendung des Spannungssensors, mindestens einer zweiten Spannungsmessung der ersten Vielzahl von Spannungsmessungen der ersten Zelle während einer zweiten Wiederherstellungsperiode nach einer zweiten Entladungsperiode, wobei die zweite Wiederherstellungsperiode auf die erste Wiederherstellungsperiode folgt (710);
wobei die erste Vielzahl von Spannungsmessungen der ersten Zelle verwendet wird, zum Anzeigen zumindest eines Abschnittes der ersten Kennlinie der ersten Zelle (904).

2. Batterieüberwachungseinrichtung (307) nach Anspruch 1, wobei die mindestens eine erste Spannungsmessung eine Vielzahl von Spannungsmessungen umfasst und die Anweisungen den Prozessor weiter veranlassen, einen Median oder Mittelwert der Vielzahl von Spannungsmessungen zu bestimmen.

3. Batterieüberwachungseinrichtung (307) nach einem vorstehenden Anspruch, wobei die mindestens eine erste Spannungsmessung eine Vielzahl von Spannungsmessungen umfasst, die in Intervallen von etwa 16 Millisekunden während der ersten Wiederherstellungsperiode erhalten werden.

4. Batterieüberwachungseinrichtung (307) nach einem vorstehenden Anspruch, weiter umfassend einen Entladekreis, der elektrisch mit der Batterie gekoppelt ist, wobei die Anweisungen den Prozessor weiter veranlassen zum:
Erhalten, unter Verwendung des Spannungssensors, einer zweiten Vielzahl von Spannungsmessungen der ersten Zelle während der Abfolge der Entladeperioden
wobei die zweite Vielzahl von Spannungsmessungen der ersten Zelle verwendet wird, zum
Anzeigen zumindest eines Abschnitts der ersten Kennlinie der ersten Zelle.

5. Batterieüberwachungseinrichtung (307) nach Anspruch 4, wobei der Entladekreis einen Entladewiderstand der Batterie umfasst.

6. Batterieüberwachungseinrichtung (307) nach einem vorstehenden Anspruch, wobei eine Länge der ersten Wiederherstellungsperiode ungefähr gleich einer Länge der ersten Entladungsperiode ist.

7. Batterieüberwachungseinrichtung (307) nach einem vorstehenden Anspruch, wobei die Anweisungen weiter den Prozessor veranlassen, zum Erzeugen
eines ersten Hinweises darauf, dass sich die Batterie während der mindestens einen ersten Spannungsmessung in der Wiederherstellungsperiode befand.

8. Batterieüberwachungseinrichtung (307) nach einem vorstehenden Anspruch, wobei das Erhalten, unter Verwendung des Spannungssensors, der ersten Vielzahl von Messungen der ersten Zelle während der Vielzahl von Wiederherstellungsperioden weiter umfasst:
Erhalten, unter Verwendung des Spannungssensors, mindestens einer dritten Spannungsmessung der ersten Vielzahl von Spannungsmessungen der ersten Zelle während einer dritten Wiederherstellungsperiode nach einer dritten Entladungsperiode (710), wobei die dritte Entladungsperiode auf die zweite Wiederherstellungsperiode folgt.

9. Batterieüberwachungseinrichtung nach einem der vorstehenden Ansprüche, wobei die zweite Wiederherstellungsperiode kürzer als die erste Wiederherstellungsperiode ist.

10. Verfahren, das von einer Batterieüberwachungseinrichtung (307) durchgeführt wird, der mit einer Batterie (305) gekoppelt ist, die mindestens eine Zelle umfasst, die mindestens eine Zelle einschließend eine erste Zelle, das Verfahren umfassend:
Verursachen einer Stromentladung aus der Batterie über eine Abfolge von Entladungsperioden (704), wobei auf jede Entladungsperiode eine Wiederherstellungsperiode folgt;
Erhalten einer ersten Vielzahl von Spannungsmessungen der ersten Zelle während Erholungsperioden, die auf jeweilige Entladeperioden folgen, unter Verwendung eines Spannungssensors, wobei das Erhalten umfasst:
Erhalten, unter Verwendung des Spannungssensors, mindestens einer ersten Spannungsmessung der ersten Vielzahl von Spannungsmessungen der ersten Zelle während einer ersten Wiederherstellungsperiode (710) nach einer ersten Entladungsperiode;
Erhalten, unter Verwendung des Spannungssensors, mindestens einer zweiten Spannungsmessung der ersten Vielzahl von Spannungsmessungen der ersten Zelle während einer zweiten Wiederherstellungsperiode (710) nach einer zweiten Entladungsperiode, wobei die zweite Entladungsperiode auf die erste Wiederherstellungsperiode folgt;
wobei die erste Vielzahl von Spannungsmessungen der ersten Zelle verwendet wird, zum Anzeigen zumindest eines Abschnitts einer ersten Kennlinie der ersten Zelle.

11. Verfahren nach Anspruch 10, weiter umfassend das Erhalten einer zweiten Vielzahl von Spannungsmessungen der ersten Zelle während der Abfolge von Entladungsperioden (706) unter Verwendung des Spannungssensors,
wobei die zweite Vielzahl von Spannungsmessungen der ersten Zelle verwendet wird, zum Anzeigen zumindest eines Abschnitts der ersten Kennlinie der ersten Zelle.

12. Verfahren nach Anspruch 10 oder Anspruch 11, wobei das Erhalten, unter Verwendung des Spannungssensors, der ersten Vielzahl von Messungen der ersten Zelle während der Vielzahl von Wiederherstellungsperioden weiter umfasst:
Erhalten, unter Verwendung des Spannungssensors, mindestens einer dritten Spannungsmessung der ersten Vielzahl von Spannungsmessungen der ersten Zelle während einer dritten Wiederherstellungsperiode (710) nach einer dritten Entladungsperiode, wobei die dritte Entladungsperiode auf die zweite Wiederherstellungsperiode folgt.

13. Batterieüberwachungseinrichtung nach einem der Ansprüche 1-9, wobei die erste Vielzahl von Spannungsmessungen der ersten Zelle zur Erzeugung der ersten Kennlinie für die erste Zelle verwendet wird, wobei die Erzeugung die Bestimmung einer Impedanz der ersten Zelle als die erste Kennlinie unter Verwendung der ersten Vielzahl von Spannungsmessungen umfasst.

14. Batterieüberwachungseinrichtung nach einem der Ansprüche 1-9 oder Anspruch 13, wobei die erste Zelle der ersten Batterie mit einer zweiten Zelle einer zweiten Batterie unter Verwendung der ersten Kennlinie für die erste Zelle abgeglichen wird.

15. Batterieüberwachungseinrichtung nach einem der Ansprüche 1-9 oder 13-14, wobei eine Identität der ersten Zelle unter Verwendung der ersten Kennlinie der ersten Zelle verifiziert wird.

## Revendications

1. Moniteur de batterie (307) couplé à une batterie (305) comprenant au moins une cellule, l'au moins une cellule incluant une première cellule, le moniteur de batterie comprenant :
un capteur de tension couplé électriquement à la batterie (305) ;
un processeur ; et
un support de stockage non transitoire lisible par ordinateur stockant des instructions qui, lorsqu'elles sont mises en œuvre par le processeur, amènent le processeur à :
provoquer la décharge de courant de la batterie au cours d'une séquence de périodes de décharge (704), chaque période de décharge étant suivie d'une période de récupération ;
obtenir, en utilisant le capteur de tension, une première pluralité de mesures de tension de la première cellule pendant des périodes de récupération qui suivent des périodes de décharge respectives, l'obtention comprenant :
obtenir, en utilisant le capteur de tension, au moins une première mesure de tension parmi la première pluralité de mesures de tension de la première cellule pendant une première période de récupération après une première période de décharge (710) ; et
obtenir, en utilisant le capteur de tension, au moins une seconde mesure de tension parmi la première pluralité de mesures de tension de la première cellule au cours d'une seconde période de récupération après une seconde période de décharge, dans lequel la seconde période de récupération est subséquente à la première période de récupération (710) ;
dans lequel la première pluralité de mesures de tension de la première cellule est utilisée pour indiquer au
moins une partie d'une première caractérisation de la première cellule (904).

2. Moniteur de batterie (307) selon la revendication 1, dans lequel l'au moins une première mesure de tension comprend une pluralité de mesures de tension et les instructions amènent en outre le processeur à déterminer une médiane ou une moyenne de la pluralité de mesures de tension.

3. Moniteur de batterie (307) selon une quelconque revendication précédente, dans lequel l'au moins une première mesure de tension comprend une pluralité de mesures de tension obtenues à des intervalles d'environ 16 millisecondes au cours de la première période de récupération.

4. Moniteur de batterie (307) selon une quelconque revendication précédente, comprenant en outre un circuit de décharge couplé électriquement à la batterie, dans lequel les instructions amènent en outre le processeur à :
obtenir, en utilisant le capteur de tension, une seconde pluralité de mesures de tension de la première cellule pendant la séquence de périodes de décharge ;
dans lequel la seconde pluralité de mesures de tension de la première cellule est utilisée pour
indiquer au moins une
partie de la première caractérisation de la première cellule.

5. Moniteur de batterie (307) selon la revendication 4, dans lequel le circuit de décharge comprend une résistance de purge de la batterie.

6. Moniteur de batterie (307) selon une quelconque revendication précédente, dans lequel une durée de la première période de récupération est approximativement égale à une durée de la première période de décharge.

7. Moniteur de batterie (307) selon une quelconque revendication précédente, dans lequel les instructions amènent en outre le processeur à générer :
une première indication que la batterie était en cours de récupération pendant l'au moins une première mesure de tension.

8. Moniteur de batterie (307) selon une quelconque revendication précédente, dans lequel l'obtention, en utilisant le capteur de tension, de la première pluralité de mesures de la première cellule pendant la pluralité de périodes de récupération comprend en outre :
l'obtention, en utilisant le capteur de tension, d'au moins une troisième mesure de tension de la première pluralité de mesures de tension de la première cellule pendant une troisième période de récupération après une troisième période de décharge (710), dans lequel la troisième période de décharge est subséquente à la deuxième période de récupération.

9. Moniteur de batterie selon une quelconque revendication précédente, dans lequel la deuxième période de récupération est plus courte que la première période de récupération.

10. Procédé mis en œuvre par un moniteur de batterie (307) couplé à une batterie (305) comprenant au moins une cellule, l'au moins une cellule incluant une première cellule, le procédé comprenant :
le fait de provoquer la décharge de courant de la batterie au cours d'une séquence de périodes de décharge (704), chaque période de décharge étant suivie d'une période de récupération ;
l'obtention, en utilisant un capteur de tension, d'une première pluralité de mesures de tension de la première cellule pendant des périodes de récupération qui suivent des périodes de décharge respectives, l'obtention comprenant :
l'obtention, en utilisant le capteur de tension, d'au moins une première mesure de tension parmi la première pluralité de mesures de tension de la première cellule pendant une première période de récupération (710) après une première période de décharge ;
l'obtention, en utilisant le capteur de tension, d'au moins une seconde mesure de tension parmi la première pluralité de mesures de tension de la première cellule au cours d'une seconde période de récupération (710) après une seconde période de décharge, dans lequel la seconde période de récupération est subséquente à la première période de récupération ;
dans lequel la première pluralité de mesures de tension de la première cellule est utilisée pour
indiquer au moins une
partie d'une première caractérisation de la première cellule.

11. Procédé selon la revendication 10, comprenant en outre l'obtention, en utilisant le capteur de tension, d'une seconde pluralité de mesures de tension de la première cellule pendant la séquence de périodes de décharge (706),
dans lequel la seconde pluralité de mesures de tension de la première cellule est utilisée pour
indiquer au moins une
partie de la première caractérisation de la première cellule.

12. Procédé selon la revendication 10 ou la revendication 11, dans lequel l'obtention, en utilisant le capteur de tension, de la première pluralité de mesures de la première cellule pendant la pluralité de périodes de récupération comprend en outre :
l'obtention, en utilisant le capteur de tension, d'au moins une troisième mesure de tension de la première pluralité de mesures de tension de la première cellule pendant une troisième période de récupération (710) après une troisième période de décharge, dans lequel la troisième période de décharge est subséquente à la deuxième période de récupération.

13. Moniteur de batterie selon l'une quelconque des revendications 1 à 9, dans lequel la première pluralité de mesures de tension de la première cellule est utilisée pour générer la première caractérisation pour la première cellule, la génération comprenant la détermination d'une impédance de la première cellule en tant que première caractérisation en utilisant la première pluralité de mesures de tension.

14. Moniteur de batterie selon l'une quelconque des revendications 1 à 9 ou la revendication 13, dans lequel la première cellule de la première batterie est appariée à une seconde cellule d'une seconde batterie en utilisant la première caractérisation pour la première cellule.

15. Moniteur de batterie selon l'une quelconque des revendications 1 à 9 ou 13 et 14, dans lequel une identité de la première cellule est vérifiée en utilisant la première caractérisation de la première cellule.
